# EUROPÄISCHE PATENTSCHRIFT

(11) **EP 2 669 694 B1**
(45) Veröffentlichungstag und Bekanntmachung des Hinweises auf die Patenterteilung: **04.07.2018**
(21) Anmeldenummer: 13002656.0
(22) Anmeldetag: 22.05.2013
(51) Int. Cl.: G01R 31/08, G01V 3/10

(54) **Verfahren und Vorrichtung zum Lokalisieren eines Kabelfehlers eines verlegten Kabels**
Method and device for localising a fault in a buried cable
Procédé et dispositif de localisation d'un défaut dans un câble enterré

(30) Priorität: 01.06.2012 DE 102012011066
(43) Veröffentlichungstag der Anmeldung: 04.12.2013
(73) Patentinhaber: Hagenuk KMT Kabelmesstechnik GmbH, 01471 Radeburg (DE)
(72) Erfinder: Marco, Stephan, D-01129 Dresden (DE)
(74) Vertreter: Marschall, Stefan

(56) Entgegenhaltungen:
- EP-A1- 1 387 175
- EP-A2- 2 405 279
- EP-A2- 2 450 716
- DD-A1- 267 336
- DE-A1- 2 138 108
- DE-A1-102010 013 613
- JP-A- S56 108 986
- Megger: "MPP1000 Pinpointer", , 3. Mai 2011 (2011-05-03), Seiten 1-2, XP002714290, Gefunden im Internet: URL:http://web.archive.org/web/20110315000 000*/http://www.techrentals.com.au/uploads /MEG_MPP1002-FAULT_PP.pdf [gefunden am 2013-10-04]

## Beschreibung

Die Erfindung betrifft ein Verfahren zur zielgeführten Lokalisierung einer Fehlerstelle eines verlegten Kabels und einer Vorrichtung hierfür.

Bei der Fehlerortung unterirdisch verlegter Kabel ist es bekannt, Fehler mit einem Bodenmikrofon zu orten, wobei der Nutzer keinerlei Information über die Lage des Sensors über der Leitung und vom Fehler hat. Der Nutzer muss sich durch probieren dem Fehler annähern indem er das Bodenmikrofon versetzt und die Koinzidenzmesswerte (Differenzzeit zwischen Eintreffen von Magnetimpuls und akustischem Impuls) vergleicht. Wird der Wert kleiner nähert er sich dem Fehler an, wird der Wert größer entfernt er sich vom Fehler.

Das Problem besteht darin, dass der Nutzer keine Information über die Lage der Leitung hat und somit auch quer zu dieser gehen kann wenn diese beispielsweise eine Kurve beschreibt. Der Nutzer erhält in diesem Fall somit größere Messwerte was ihm suggeriert, dass er sich von der Fehlerstelle entfernt. Hierbei handelt es sich jedoch um Fehlmessungen.

Um dies zu vermeiden, ist es bekannt, ein vorheriges Trassieren des Kabels mittels Tonfrequenzsende- und Empfangsanlage durchzuführen und dabei die Lage des verlegten Kabels zu ermitteln.

Somit müssen zur Fehlerortung nacheinander grundsätzlich zwei zeitaufwändige Messverfahren durchgeführt werden. Zum einen das Trassieren und anschließend die eigentliche Fehlerortung.

Aus dem Stand der Technik sind Fehlerortungssysteme bekannt, welche zwei akustische Sensoren aufweisen und einen Laufzeitunterschied eines Schallsignals einer Schallpunktquelle ermitteln, und zusätzlich ein Magnetfeld bestimmen, welches mit einer Spule gemessen wird.

In der DE 2138 108 ist ein Verfahren offenbart zur sicheren und genauen Fehlerortsbestimmung an Kabeln, bei dem an der Fehlerstelle durch eine Prüfgleichspannung kräftige Überschläge erzeugt werden und das durch den Überschlag verursachte akustische Signal sowie das magnetische Signal einer Wanderwelle zur Bildung eines Messwertes und/oder einer Anzeige empfangen werden.

In der JP 56 10 89 86 A ist ein elektromagnetisches Verfahren zur Trassenortung von elektrischen Leitungen offenbart, bei welchem ein Sensornetz aus Magnetfeldsensoren zur Positionsbestimmung verwendet wird.

Aufgabe der Erfindung ist es den Stand der Technik zu verbessern und das Trassieren eines verlegten Kabels sowie eine Richtungsausführung zur Lokalisierung einer Fehlerstelle zur Lokalisierung einer Fehlerstelle gleichzeitig zu gewährleisten.

Gelöst wird die Aufgabe durch ein Verfahren mit den Merkmalen des Anspruchs 1.

Somit kann ermittelt werden, ob die Messposition direkt oberhalb des verlegten Kabels verortet ist oder in welcher Richtung sich das verlegte Kabel befindet.

Weiterhin kann eine alternative Messmethode zum Trassieren eines Kabels bereitgestellt werden, da selbst ohne Einkoppeln eines akustischen Signals (z.B. sehr weit von einem Kabelfehler entfernt) die Leitung mittels der Links-/Rechts-Detektion trassierbar ist.

Somit kann ein Verfahren zur schnellen Ortung eines Überschlagfehlers in einer elektrischen Leitung, welcher beispielsweise mit Hilfe eines Stoßspannungsgenerators erzeugt wird, ohne vorherigen Einsatz eines Tonfrequenzsender und - empfängers zur Trassierung bereitgestellt werden. Hierbei kann der Nutzer vorteilhafter Weise sowohl eine Information zur Position über dem Kabel als auch eine Richtungsanzeige zum Fehler hin erhalten. Insbesondere kann ein Nutzer schneller eine Fehlerstelle finden.

Die Informationen dieser Position und Bewegungsrichtung zum Fehler können kombiniert und als Richtungspfeil auf einem Display dargestellt werden. Das Display kann dem Nutzer so mitteilen in welcher Richtung sich die Leitung/das Kabel bzw. die Fehlerstelle befindet.

Auch müssen nun Trassierung und Fehlerortung nicht nacheinander erfolgen, sondern können gleichzeitig erfolgen. Dies hat eine enorme Zeitersparnis zur Folge.

Folgendes Begriffliche sei für das vorliegende Dokument erläutert:

Unter einem "Trassieren" ist jegliches Verorten eines nicht sichtbaren Kabels umfasst. Insbesondere ist ein Verorten einer einzigen Kabelposition von diesem Begriff umfasst.

Als "Kabelposition" wird insbesondere eine vertikale oder horizontale Position oberhalb oder neben dem Kabel verstanden, sodass bei einem Freilegen im Regelfall das Kabel auf direktem Weg erreicht wird. Insbesondere umfasst der Begriff "Kabelposition" den kürzesten Abstand von Messort und Kabel. Auch bei geringen Abweichungen wird noch von Kabelposition ausgegangen, da Messfehler eine gewisse Fehlerbreite generieren. Der Fehler ist insbesondere von der Verlegungstiefe des Kabels abhängig. Fehler reichen von einigen Dezimetern bis zu einigen Metern.

Eine "Fehlerrichtung" ist eine Information darüber in welcher Richtung eine nächste Messung erfolgen müsste, um den Abstand zur Fehlerstelle im Kabel zu verringern.

Als "Kabel" werden sämtliche ein- und mehradrige (strom-)leitende Kabel verstanden. Insbesondere sind Mittelspannungs-und Hochspannungskabel umfasst.

Unter "verlegtem" Kabel werden nicht nur erdverlegte Kabel verstanden, sondern auch sämtliche anderweitig nicht direkt zugängliche Kabel wie beispielsweise Stromkabel in einer Hauswand.

Der "Stromimpuls" zeichnet sich insbesondere durch steile Signalflanken aus, welche insbesondere die Phasenlage des detektierbaren Magnetfeldes im Kabel beeinflussen. Der Stromimpuls wird insbesondere mittels eines Stoßspannungsgenerators dem Kabel aufgeprägt. Auch ein Spannungsimpuls ist von der Begrifflichkeit "Stromimpuls" umfasst, da aufgrund des Kabelwiderstandes ein Spannungspuls einen Stromimpuls bewirkt. Die Zeitdauer des Kabelimpulses kann einige Mikrosekunden umfassen. Zudem kann der Kabelimpuls unterschiedliche Stromimpulssignalformen aufweisen.

Das "externe" Bestimmen der Magnetfeldinformation erfolgt insbesondere überirdisch. Ein externes Bestimmen ist immer dann gegeben, solange keine destruktiven Handlungen, wie beispielsweise ein Aufgraben des Erdreichs oder ein Aufstemmen einer Wand, erforderlich sind.

"Magnetfeldinformationen" umfassen insbesondere B-Feldstärken und deren Verläufe. "Orthogonale" Magnetfeldinformationen werden insbesondere mittels orthogonal zueinander versetzten Magnetfeldsensoren bestimmt. Auch mit nicht orthogonal zueinander angeordneten Sensoren (z.B. mit einem Winkel von 45° zwischen den Sensoren) können die orthogonalen Magnetfeldinformationen mathematisch ermittelt und somit bestimmt werden.

Ein "Lokalisieren eines Kabelfehlers" umfasst das örtliche Einschränken des Fehlerortes. Insbesondere dadurch, dass durch das Trassieren der Verlauf des Kabels bekannt ist, kann der Ort des Kabelfehlers extern (z.B. überirdisch) gut bestimmt werden.

Durch den Begriff "Kabelfehler" sind sämtliche Ereignisse in einem Kabel umfasst, bei denen das Aufprägen eines Stromimpulses/Spannungsimpulses einen Stromüberschlag induziert, sodass ein akustisches (Überschlags-)Signal erzeugt wird. Ein solches akustisches (Überschlags-) wird vorliegend als "Akustiksignal" bezeichnet. Kabelfehler sind u.a. gebrochene Leitungen oder beschädigte Isolationen des Kabels.

"Messposition" ist insbesondere der Ort an dem eine Messung erfolgt. Bei der Messung kann sowohl die Kabelposition/Kabelrichtung als auch die Laufzeit des akustischen Signals oder entsprechend die Zeitdifferenz zwischen der Magnetfeldinformation und des akustischen Signals bestimmt werden.

Das "Akustiksignal" ist insbesondere ein Signal welches beim Spannungsüberschlag erzeugt wird und mittels Mikrofon gemessen wird.

Um eine möglichst einfache Möglichkeit zum Bestimmen der Kabelrichtung oder Kabelposition bereitzustellen, kann die Magnetfeldinformation eine Phasenlage einer Magnetfeldmessung umfassen.

In einer weiteren Ausgestaltung erfolgt ein Nivellieren einer Messvorrichtung, wobei das externe Bestimmen der orthogonalen Magnetfeldinformation innerhalb der Messvorrichtung durchgeführt wird. Somit kann ein optimiertes Verfahren bereitgestellt werden, da Verkippungen beim Messen unterbleiben und Fehler beim Trassieren minimiert werden können.

Ein "Nivellieren" umfasst insbesondere ein horizontales Ausrichten. Dies kann insbesondere dadurch erfolgen, dass die Messvorrichtung mit einer flachen horizontalen Unterseite auf dem (horizontalen) Erdboden aufgesetzt wird. Zudem kann dies durch (elektronische) Libellen gewährleistet werden.

Somit kann eine einfache konstruktive Umsetzung für das Bestimmen der Magnetfeldinformation bereitgestellt werden.

In einer Ausführungsform werden an weiteren Messpositionen jeweils eine Zeitdifferenz zwischen dem jeweiligen Akustiksignals und der jeweiligen Magnetfeldinformation und insbesondere die jeweilige Fehlerrichtung ermittelt.

Somit kann ein Nutzer sich allmählich dem Fehlerort nähern.

Um eine zuverlässige Information bzgl. des Fehlerortes zu erhalten, kann ein Minimum der Zeitdifferenz ermittelt werden. Dies kann erfolgen, da die Zeitdifferenz mit zunehmendem Abstand vom Fehlerort größere Werte annimmt.

In einer weiteren Ausgestaltungsform erfolgt das Ermitteln der jeweiligen Zeitdifferenz senkrecht oberhalb des verlegten Kabels. Insbesondere durch die Kenntnis des Kabelverlaufs aufgrund des Trassierens kann dies vorteilhaft sein.

Um eine Positionsänderung messtechnisch zu detektieren, kann ein Ändern von der ersten Messposition zur zweiten Messposition insbesondere mittels eines Bewegungssensors ermittelt werden.

In einem weiteren Aspekt der Erfindung wird die Aufgabe gelöst durch eine Vorrichtung mit den Merkmalen des Anspruchs 6.

Weitere vorteilhafte Verfahrensschritte sind durch die abhängigen Ansprüche gekennzeichnet. Die Erfindung wird in den Zeichnungen anhand von schematischen Darstellungen näher erläutert. Es zeigen:
- Figur 1: eine Darstellung eines vertikalen Schnitts durch einen Erdboden mit einem verlegten Kabel,
- Figur 2 A,B,C: einen vertikalen Schnitt aus Fig. 1 mit verschiedenen Messpositionen und jeweils zugehöriges Messsignal zweier orthogonaler Spulen,
- Figur 3: eine räumliche Anordnung von orthogonalen Spulen,
- Figur 4: ein Messprinzip zum Lokalisieren eines Kabelfehlers im Erdreich in einer Schnittdarstellung,
- Figur 5: eine Blockdarstellung einer Richtungsauswertung,
- Figur 6: einen Ortungsvorgang mit ermittelten Richtungspfeilen eines im Erdreich verlegten Kabels in einer Draufsicht und
- Figur 7: eine Displayanzeige.

Bei den Ausführungsbeispielen ist im Erdreich unterhalb eines Erdbodens 109 ein Mittelspannungskabel 101 verlegt. Bei Stromfluss bilden sich Magnetfeldlinien 103 aus.

Auf dem Erdboden 109 ist eine Fehlerlokalisierungsvorrichtung 105 aufgesetzt. Die Fehlerlokalisierungsvorrichtung 105 umfasst einen Bodenschallaufnehmer 107 und eine Trassiervorrichtung mit zwei orthogonalen Spulen L1, L2.

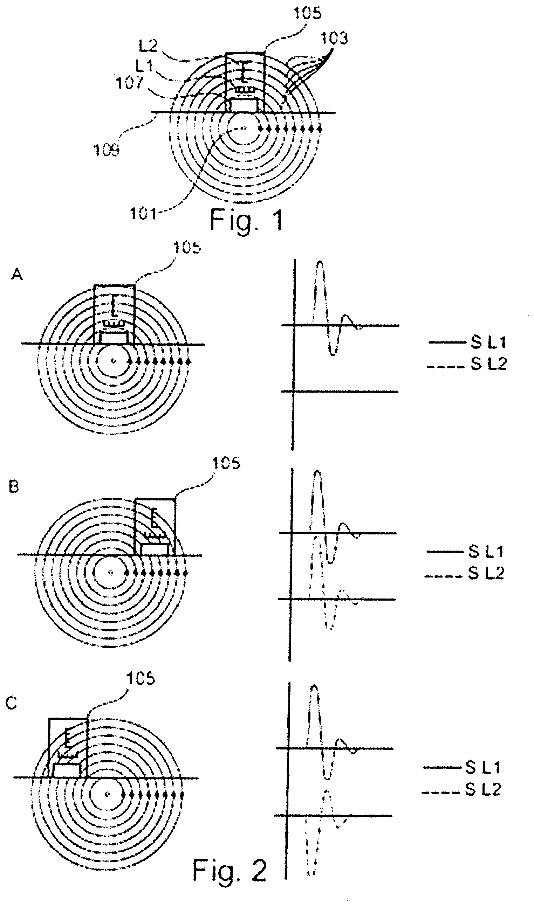

In Figur 2A ist die Situation dargestellt, dass die Fehlerlokalisierungsvorrichtung 105 direkt oberhalb des Mittelspannungskabels 101 angeordnet ist. In den Figuren 2B und 2C sind die Situationen dargestellt, in denen die Fehlerlokalisierungsvorrichtung 105 vertikal betrachtet rechts und links angeordnet sind.

Wird nun jeweils in den Situationen der Fig. 2A,B,C dem Mittelspannungskabel ein Stromimpuls durch den Stoßgenerator 425 aufgeprägt, messen die orthogonalen Spulen L1 und L2 jeweils die in den Figuren 2A,B,C rechts dargestellten Signale.

Ist die Fehlerlokalisierungsvorrichtung 105 vertikal oberhalb des Kabels 101 angeordnet, wird die Spule L2 nicht vom Magnetfeld 103 angeregt und ermittelt somit kein Signal. Spule L1 wird vom Magnetfeld 103 erregt und ermittelt ein Signal, woraus gefolgert wird das Kabel unterhalb verlegt ist.

Die gemessenen Signalverläufe der Spule L2 für den Fall, dass die Fehlerlokalisierungsvorrichtung 105 nicht direkt vertikal oberhalb des Kabels 101 angeordnet sind und die entsprechenden Phasenverläufe der Spulen L1, L2 können den Figuren 2B und 2C entnommen werden.

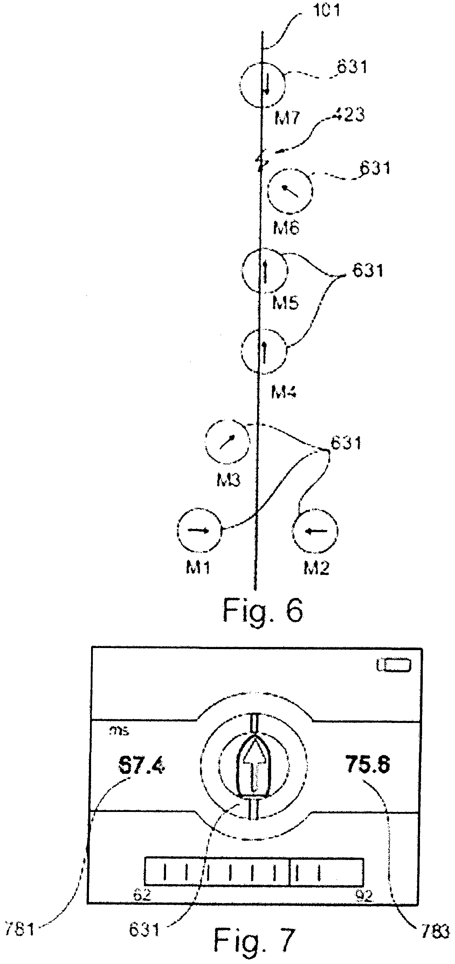

Aufgrund der Phasenlage der durch die Spule L2 und L1 gemessenen Signale wird die Richtung zum Kabel ermittelt und im Display angezeigt (siehe Figur 7). Durch mehrere Messungen wird das Kabel 101 trassiert, sodass der Verlauf des unterirdischen Kabels überirdisch bestimmt ist.

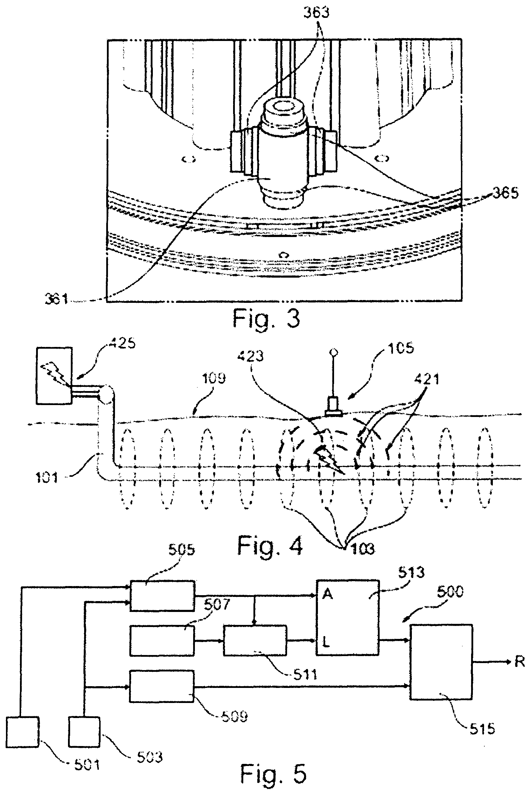

Die eigentliche Spulenanordnung kann der Fig. 3 entnommen werden. Die Spule L1 (Bezugszeichen 363) und die Spule L2 (Bezugszeichen 365) sind fest mit der Fehlerlokalisierungsvorrichtung 105 über eine Halterung 361 verbunden.

Ein Verfahren zum Lokalisieren eines Kabelfehlers wird anschaulich anhand Fig. 4 näher erläutert.

Ein Stoßgenerator 425 prägt dem Mittelspannungskabel 101 einen Stromimpuls auf. Dieser Stromimpuls induziert ein Magnetfeld 103. An der Kabelfehlerstelle 423 generiert der Stromimpuls einen Spannungsüberschlag. Der Spannungsüberschlag erzeugt ein akustisches Signal 421, welches über das Erdreich ausgebreitet wird.

Mittels der Fehlerlokalisierungsvorrichtung 105 werden sowohl die Magnetfeldsignale mittels der Spulen 365, 363 als auch mittels des Bodenschallaufnehmers 107 die akustischen Signale gemessen. Zudem wird die Zeit vom Detektieren des Magnetfeldsignals zum Detektieren des akustischen Signals gemessen (Koinzidenzmessung).

Für den Fall, dass die Fehlerlokalisierungsvorrichtung 105 direkt oberhalb des Ortes des Kabelfehlers angeordnet ist, ergibt sich für den Wert der Koinzidenzmessung ein Minimum.

Zum effektiven Auffinden des Kabelfehlers werden das beschriebene Verfahren zum Trassieren und das beschriebene Verfahren zum Lokalisieren des Kabelfehlers kombiniert.

Ein Beispiel einer solchen kombinierten Messung ist in Fig. 6 dargestellt. Die Messung erfolgt nach folgendem Protokoll:

| **Messposition** | **Ergebnis der Phasenbewertung** | **Ergebnis des Vergleiches der Differenszeit-Messergebnisse** | **Ausgabe** |
|---|---|---|---|
| Messung M1 | Sensor links der Leitung | Kein Vergleichsergebnis da erste Messung | Ziel (Leitung) befindet sich rechts |
| Messung M2 | Sensor rechts der Leitung | Ergebnis Neu = Alt | Keine Entfernungsänderung zum Fehler → Anzeige Ziel (Leitung) befindet sich links |
| Messung M3 | Sensor links der Leitung | Ergebnis Neu < Alt | Nutzer bewegt sich auf Fehler zu und ist links der Leitung → Anzeige Ziel vornrechts |
| Messung M4 | Sensor über Leitung | Ergebnis Neu < Alt | Nutzer bewegt sich auf Fehler zu und ist auf der Leitung → Anzeige Ziel vorn |
| Messung M5 | Sensor über Leitung | Ergebnis Neu < Alt | Nutzer bewegt sich auf Fehler zu und ist auf der Leitung → Anzeige Ziel vorn |
| Messung M6 | Sensor rechts der Leitung | Ergebnis Neu < Alt | Nutzer bewegt sich auf Fehler zu und ist rechts der Leitung → Anzeige Ziel vornlinks |
| Messung M7 | Sensor über Leitung | Ergebnis Neu > Alt | Messwert wird größer, somit entfernt sich der Nutzer vom Fehler → Anzeige Ziel zurück |

Die Ausgabe für den Nutzer erfolgt über ein Display (siehe Fig. 7). Dabei wird sowohl die Koinzidenzzeit des Messwertes der neuen Messposition (781) als auch der Messwert der vorherigen Messposition (783) angezeigt. Die Richtungsangabe 631 zeigt in Fehlerrichtung (Nord/Süd), in Kabelrichtung (links/rechts) oder aber als Kombination beider Informationen diagonal.

Zusammenfassend wird das Verfahren zum Verdeutlichen anhand der Fig. 5 erläutert. Dem Kabel 101 werden Stromimpulse durch den Stoßgenerator aufgeprägt (nicht dargestellt). Die Magnetfeldinformationen 503 und die akustischen Sensordaten 501 werden aufgenommen. Es wird sowohl die Kabelrichtung 509 als auch der Differenzwert 505 der Koinzidenzmessung ermittelt. Der gemessene Koinzidenzmesswert wird im Messwertspeicher 511 abgelegt.

Wird die Fehlerlokalisierungsvorrichtung 105 durch den Nutzer an eine neue Position auf dem Boden abgestellt, erkennt dies der Bewegungssensor 507. Es werden erneut die Kabelrichtung 509 und der Differenzwert 505 der Koinzidenz gemessen. Der neue (aktuelle) Koinzidenzwert wird dem Vergleicher 513 am Eingang A zugeführt. Der im Speicher 511 zuvor abgelegte (letzte) Koinzidenzwert wird dem Vergleicher 513 am Eingang L zugeführt.

Der Vergleicher 513 liefert ein Fehlerrichtungssignal, welches mit der Kabelrichtung 509 verknüpft 515 wird, sodass letztendlich eine Richtung R ausgegeben wird. In diese Richtung sollte sich der Nutzer bewegen, um sich dem Fehlerort zu nähern.

## Patentansprüche

1. Verfahren zum Lokalisieren eines Kabelfehlers eines verlegten Kabels, welches folgende Schritte aufweist
- dem verlegten Kabel einen Stromimpuls aufprägen, sodass ein Magnetfeld (103) induziert wird und ein Kabelüberschlag erfolgt,
- externes Bestimmen einer ersten orthogonalen Magnetfeldinformation (503) an einer ersten Messposition, wobei die erste Magnetfeldinformation eine Phasenlage einer Magnetfeldmessung mittels zweier orthogonaler Magnetfeldsensoren umfasst,
- Ermitteln einer Kabelrichtung (509) oder Kabelposition mittels der Magnetfeldinformation
- Bestimmen eines Akustiksignals des Kabelfehlerüberschlages, an der ersten Messposition,
- Ermitteln einer ersten Zeitdifferenz zwischen der Detektion der ersten orthogonalen Magnetfeldinformation und der Detektion des Akustiksignals an der ersten Messposition,
- Verändern der Messposition, sodass eine zweite Messposition eingenommen wird, und Aufprägen eines Stromimpulses, sodass ein Magnetfeld induziert wird und ein Kabelüberschlag erfolgt,
- externes Bestimmen einer zweiten orthogonalen Magnetfeldinformation an der zweiten Messposition, wobei die zweite Magnetfeldinformation eine Phasenlage einer Magnetfeldmessung mittels zweier orthogonaler Magnetfeldsensoren umfasst,
- Bestimmen eines Akustiksignals des Kabelfehlerüberschlags, welcher sich durch das Aufprägen des Stromimpulses ergibt, an der zweiten Messposition,
- Ermitteln einer zweiten Zeitdifferenz zwischen der Detektion der zweiten orthogonalen Magnetfeldinformation und der Detektion des Akustiksignals an der zweiten Messposition und
- Ermitteln einer Kabelrichtung sowie Ermitteln einer Fehlerrichtung durch ein Vergleichen der ersten Zeitdifferenz mit der zweiten Zeitdifferenz.

2. Verfahren nach Anspruch 1, **dadurch gekennzeichnet, dass** der aufgeprägte Stromimpuls mittels eines Stoßspannungsgenerators erzeugt wird.

3. Verfahren nach einem der vorherigen Ansprüche, **dadurch gekennzeichnet, dass** ein Nivellieren einer Messvorrichtung erfolgt, wobei das externe Bestimmen der orthogonalen Magnetfeldinformation innerhalb der Messvorrichtung durchgeführt wird.

4. Verfahren nach einem der vorherigen Ansprüche, **dadurch gekennzeichnet, dass** an weiteren Messpositionen jeweils eine Zeitdifferenz zwischen dem jeweiligen Akustiksignals und der jeweiligen Magnetfeldinformation ermittelt und die jeweilige Fehlerrichtung (R) ermittelt wird.

5. Verfahren nach einem der vorherigen Ansprüche, **dadurch gekennzeichnet, dass** eine Änderung der Messposition mittels eines Bewegungssensors ermittelt wird.

6. Vorrichtung (105) zum Lokalisieren eines Kabelfehlers eines verlegten Kabels, welche Mittel zur Durchführung aller Schritte eines Verfahrens nach einem der vorherigen Ansprüche umfasst.

## Claims

1. A method for localising a cable fault of a laid cable, comprising the following steps:
- impressing a current impulse on the laid cable so that a magnetic field (103) is induced and a cable flashover occurs,
- externally determining a first orthogonal magnetic field information (503) at a first measuring position, wherein the first orthogonal magnetic field information (503) comprises a phase position of a magnetic field measured by means of magnetic field sensors,
- ascertaining a cable direction (509) or cable position by means of the magnetic field information,
- determining an acoustic signal of the cable fault flashover at the first measuring position,
- ascertaining a first time difference between the detection of the first orthogonal magnetic field information and the detection of the acoustic signal at the first measuring position,
- changing the measuring position, so that a second measuring position is assumed, and impressing a current impulse, so that a magnetic field is induced and a flashover occurs,
- externally determining a second orthogonal measuring position, wherein the second magnetic field information comprises a phase position of a magnetic field measured by means of two orthogonal magnetic field sensors,
- determining an acoustic signal of the cable fault flashover resulting from impressing the current impulse at the second measuring position,
- ascertaining a second time difference between the detection of the second orthogonal magnetic field information and the detection of the acoustic signal at the second measuring position, and
- ascertaining a cable direction as well as ascertaining a fault direction by comparing the first time difference to the second time difference.

2. The method according to claim 1, **characterised in that** the impressed current impulse is generated by means of a surge voltage generator.

3. The method according to one of the preceding claims, **characterised in that** a levelling of a measuring device is carried out, wherein external determination of the orthogonal magnetic field information is performed within the measuring device.

4. The method according to one of the preceding claims, **characterised in that** a time difference is ascertained respectively at further measuring positions between the respective acoustic signal and the respective magnetic field information with the respective fault direction (R) being ascertained.

5. The method according to one of the preceding claims, **characterised in that** changing the measuring position is ascertained by means of a movement sensor.

6. A device (105) for localising a cable fault in a laid cable, which comprises means for performing all steps of a method according to one of the preceding claims.

## Revendications

1. Procédé de localisation d'un défaut de câble d'un câble posé, qui présente les étapes suivantes consistant à
- appliquer au câble posé une impulsion de courant, dès qu'un champ magnétique (103) est induit et un retournement de câble se produit,
- déterminer de manière externe une première information de champ magnétique orthogonal (503) à une première position de mesure, dans lequel la première information de champ magnétique comprend une position de phase d'une mesure de champ magnétique au moyen de deux capteurs de champ magnétique orthogonal,
- déterminer une direction de câble (509) ou une position de câble au moyen de l'information de champ magnétique,
- déterminer un signal acoustique de retournement erroné de câble, à la première position de mesure,
- déterminer une première différence temporelle entre la détection de la première information de champ magnétique orthogonal et la détection du signal acoustique à la première position de mesure,
- varier la position de mesure, dès qu'une deuxième position de mesure est adoptée et appliquer une impulsion de courant, dès qu'un champ magnétique est induit et qu'un retournement de câble se produit,
- déterminer de manière externe une deuxième information de champ magnétique orthogonal à la deuxième position de mesure, dans laquelle la deuxième information de champ magnétique comprend une position de phase d'une mesure de champ magnétique au moyen de deux capteurs de champ magnétique orthogonale,
- déterminer un signal acoustique du retournement erroné de câble, qui résulte de l'application de l'impulsion de courant, à la deuxième position de mesure,
- déterminer une deuxième différence temporelle entre la détection de la deuxième information de champ magnétique orthogonal et la détection du signal acoustique à la deuxième position de mesure et
- déterminer une direction de câble ainsi que déterminer une direction de défaut par l'intermédiaire d'une comparaison de la première différence temporelle avec la deuxième différence temporelle.

2. Procédé selon la revendication 1, caractérisé » en ce que l'impulsion de courant appliquée est générée au moyen d'un générateur de surtension transitoire.

3. Procédé selon une des revendications précédentes, **caractérisé en ce qu'**un nivellement d'un dispositif de mesure a lieu, dans lequel la détermination externe de l'information de champ magnétique orthogonal est effectuée à l'intérieur du dispositif de mesure.

4. Procédé selon une des revendications précédentes, **caractérisé en ce qu'**à d'autres positions de mesure une différence temporelle respective entre le signal acoustique respectif et l'information de champ magnétique respectif est déterminée et la direction de défaut respective (R) est déterminée.

5. Procédé selon une des revendications précédentes, **caractérisé en ce qu'**une variation de la position de mesure est déterminée au moyen d'un capteur de mouvement.

6. Dispositif (105) de localisation d'un défaut de câble d'un câble posé, qui comprend des moyens pour mettre en oeuvre toutes les étapes d'un procédé selon une des revendications précédentes.
